# EUROPÄISCHE PATENTANMELDUNG

(11) **EP 0 947 849 A2**
(43) Veröffentlichungstag der Anmeldung: **06.10.1999**
(21) Anmeldenummer: 99104969.3
(22) Anmeldetag: 12.03.1999
(51) Int. Cl.: G01R 33/3815, H01L 39/14

(54) **Supraleitende Einrichtung mit Leitern aus Hoch-Tc-Supraleitermaterial**

(30) Priorität: 25.03.1998 DE 19813211
(71) Anmelder: SIEMENS AKTIENGESELLSCHAFT, 80333 München (DE)
(72) Erfinder: Steinmeyer, Florian, Dr., 91074 Herzogenaurach (DE)

(57) **Zusammenfassung**

Die supraleitende Einrichtung (2) enthält ein raumtemperaturseitiges Vakuumgehäuse (4), in dem sich mindestens eine supraleitende Wicklung (3) mit auf unter 77 K gehaltenem Hoch-T_{c}-Supraleitermaterial befindet. Zur thermischen Isolation sollen alle zwischen der Wicklung (3) und dem Vakuumgehäuse (4) befindlichen thermischen Isolationsmittel (8a, 8b) ungekühlt sein. Die supraleitende Einrichtung kann insbesondere ein Magnet einer Kernspintomographie-Anlage sein.

## Beschreibung

Die Erfindung bezieht sich auf eine supraleitende Einrichtung mit einem raumtemperaturseitigen Vakuumgehäuse, in dem sich mindestens eine supraleitende Wicklung befindet, deren Leiter ein Hoch-T_{c}-Supraleitermaterial enthalten und auf einem Temperaturniveau unterhalb von 77 K gehalten sind, und mit thermischen Isolationsmitteln zwischen der Wicklung und dem Vakuumgehäuse. Eine entsprechende supraleitende Einrichtung geht z.B. aus 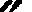 *Cryogenics*"*, Vol. 35, No. 2, 1995, Seiten 127 bis 133* hervor.

Es sind supraleitende Metalloxidverbindungen mit hohen Sprungtemperaturen T_{c} von über 77 K bekannt, die deshalb auch als Hoch-T_{c}-Supraleitermaterialien oder HTS-Materialien bezeichnet werden und vielfach mit Flüssig-Stickstoff (LN₂) bei einer Temperatur von etwa 77 K gekühlt werden. Unter solche Metalloxidverbindungen fallen insbesondere Cuprate von speziellen Stoffsystemen wie insbesondere vom selten-erd-haltigen Basistyp Y-Ba-Cu-O oder vom selten-erd-freien Basistyp Bi-Sr-Ca-Cu-O, wobei die Bi-Komponente insbesondere durch Pb teilweise substituiert sein kann. Mit diesen Supraleitermaterialien werden Supraleiter in Draht- oder insbesondere in Bandform entwickelt, die unter anderem auch zum Aufbau von Magnetwicklungen z.B. in Transformatoren, supraleitenden Energiespeichern oder Magneten von Kernspintomographie- bzw. MRI(Magnet Resonance Imaging)- bzw. NMR (Nuclear Magnetic Resonance)-Anlagen dienen sollen.

Es zeigt sich jedoch, daß entsprechende Leiter trotz ihrer hohen Sprungtemperatur T_{c} von beispielsweise 80 bis 110 K auf Temperaturen von höchstens 20 bis 50 K gehalten werden müssen, um bei geforderten Feldstärken von etwa 0,1 bis einigen Tesla nennenswerte Ströme tragen zu können. Entsprechende Temperaturen liegen zwar einerseits deutlich höher als 4,2 K, der Siedetemperatur von flüssigem Helium (LHe), auf der Leiter mit klassischem metallischen Supraleitermaterial wie z.B. NbTi gehalten werden. Andererseits ist eine Kühlung mit LN₂ bei 77 K wegen der verhältnismäßig hohen Temperatur unwirtschaftlich. Andere verflüssigte Gase wie Wasserstoff (Siedetemperatur: 20,4 K) und Neon (Siedetemperatur: 27,1 K) scheiden wegen ihrer Gefährlichkeit oder mangelnder technischer Verfügbarkeit aus.

Nach dem Stand der Technik geht man davon aus, daß für große Kryostat- und Magnetspulensysteme bei Temperaturen um 15 bis 40 K für einen wirtschaftlichen Betrieb mindestens ein Strahlungsschild erforderlich ist, der von flüssigem Stickstoff (77 K) oder einer Kältemaschine, z.B. einer einstufigen Maschine oder der ersten Stufe einer zweistufigen Maschine auf ca. Bis 80 K gehalten wird. Für den Bau entsprechender Strahlungsschilde ist ein beträchtlicher mechanischer Aufwand erforderlich:
a) Der Strahlungsschild muß in der Regel in einer komplizierten Geometrie gebaut werden, da er der Form der Magnetwicklung und des sie umgebenden Vakuumgehäuses angepaßt sein muß. Ein Beispiel einer entsprechenden aufwendigen Geometrie ist z.B. eine Toroid-Form.
b) Die Aufhängung des Strahlungsschildes muß über Elemente mit geringer Wärmeleitfähigkeit erfolgen.
c) Die Ankopplung an die Kaltfläche einer Kältemaschine ist in vielen Anwendungen aufwendig: Wegen der regelmäßig nötigen Wartung entsprechender Kältemaschinen ist nämlich in der Regel eine lösbare Verbindung mit hoher thermischer Leitfähigkeit erforderlich. Des weiteren muß die Verbindung mechanisch weich gestaltet werden, um die mechanischen Schwingungen der Kältemaschine von Strahlungsschild fern zu halten. So könnten sonst z.B. in Magneten von Kernspintomographie-Anlagen Wirbelströme entstehen, die die Bildgebung stören würden.

Bei bekannten Supraleitungsmagneten mit HTS-Material wird bisher stets ein Strahlungsschild vorgesehen, der mit gezielten Maßnahmen auf einer Zwischentemperatur zwischen der tiefen Betriebstemperatur der Magnetwicklung und einem sie umgebenden, auf Raumtemperatur liegenden Gehäuse gehalten wird. Ein entsprechender, als ein thermisches Isolationsmittel anzusehender Strahlungsschild eines Magneten geht z.B. aus der eingangs genannten Literaturstelle aus 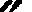 Cryogenics" hervor. Der Strahlungsschild dieses bekannten Magneten umgibt dabei eine Magnetwicklung aus Leitern mit dem Hoch-T_{c}-Supraleitermaterial Bi-2212-Cuprat, das mittels einer zweistufigen Kältemaschine, einem Gifford-McMahon(GM)-Cryocooler, auf etwa 20 K gehalten wird. Der Strahlungsschild ist dabei an die erste Stufe dieser Kältemaschine thermisch angekoppelt und liegt deshalb auf einer vergleichsweise wesentlich höheren Temperatur als die Magnetwicklung. Der Aufbau aus Magnetwicklung und sie umgebendem Strahlungsschild befindet sich dabei in einem evakuierten Vakuumgehäuse, das auf Raumtemperatur liegt. Ein entsprechender Supraleitungsmagnet ist auch aus 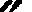 *Applied Superconductivity*"*, Vol.2, No. 3/4, 1994, Seiten 237 bis 250* zu entnehmen.

Darüber hinaus ist es auch bekannt, den Strahlungsschild eines solchen Aufbaus mit einem weiteren, einstufigen Kryokühler auf etwa 40 bis 80 K zu halten.

Aufgabe der vorliegenden Erfindung ist es, den Aufbau der supraleitenden Einrichtung mit den eingangs genannten Merkmalen zu vereinfachen.

Zur Lösung dieser Aufgabe ist gemäß der Erfindung vorgesehen, daß alle zwischen der supraleitenden Wicklung und dem Vakuumgehäuse befindlichen thermischen Isolationsmittel ungekühlt sind.

Das Problem der Kühlung einer Wicklung mit HTS-Material durch eine Kältemaschine wird also so gelöst, daß die Wicklung gegen äußere Wärmestrahlung unter völligem Verzicht auf Strahlungsschilde nur durch an sich bekannte, nicht durch besondere Kühlungsmaßnahmen gezielt gekühlten Isolationsmittel wie z.B. viellagige Superisolationsfolien, Isolationsvliese, Isolationspulver oder geschäumtes Isolationsmaterial isoliert wird. Die genannten Isolationsmittel können gegebenenfalls auch miteinander kombiniert sein. Bei der Erfindung wird also von der üblichen Praxis einer Verwendung von Strahlungsschilden abgegangen. Durch den Verzicht auf einen Strahlungsschild wird zwar die Wärmelast auf die supraleitende Wicklung vergrößert; jedoch verringert sich vorteilhaft die mechanische Komplexität des Aufbaus deutlich. D.h., die Bauweise ohne Strahlungsschild ermöglicht sehr viel kompaktere Kryosysteme, so daß bei gleichem nutzbaren Magnetfeldvolumen die Wicklung kleiner und dementsprechend preiswerter aufgebaut werden kann und/oder mehr Nutzraum für den Anwender bleibt. Dies ist insbesondere bei Magnetsystemen einer Kernspintomographie-Anlage von höchster Bedeutung, da dort stets ein Kompromiß zwischen Preis, Gewicht und dem Patientenraum eingegangen werden muß. Insbesondere bei der sogenannten interventionellen Kernspintomographie (mit minimal invasiven Eingriffen mit ständiger Operationskontrolle durch MRI-Bilder) kann so der Zugang für das medizinische Personal erweitert werden. Aber auch bei mobilen Transformatorsystemen oder Energiespeichern oder Generatoren oder Motoren als supraleitenden Einrichtungen gemäß der Erfindung ist eine Volumenreduzierung von großer Bedeutung.

Besonders vorteilhaft ist es, wenn zur Kühlung der HTS-Wicklung eine Kältemaschine mit geschlossenem He-Druckkreislauf vorgesehen ist. Eine solche Kältemaschine kann ein Gifford-McMahon-Kühler oder ein Stirling-Kühler oder ein Pulsröhrenkühler (vgl. z.B. 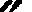 *INFO PHYS TECH*" *des VDI-Tecnnologiezentrums, Nr. 6/Febr. 1996, mit dem Titel:* 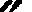 *Pulsröhrenkühler: Neue Kältemaschinen für die Supraleitungstechnik und Kryoelektronik*"*, 4 Seiten*) sein. Solche Kühler besitzen zudem den Vorteil, daß die Kälte 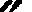 auf Knopfdruck" zur Verfügung steht und dem Anwender die Handhabung von tiefkalten Flüssigkeiten erspart wird. Bei dieser Kühlart wird die Kühlung der supraleitenden Einrichtung, z.B. von einer Magnetspule oder einem Transformator, nur durch Wärmeleitung zum Kaltkopf eines Refrigerators indirekt gekühlt. Als besonders vorteilhaft ist auch die Verwendung mindestens eines Pulsröhrenkühlers anzusehen.

Weitere vorteilhafte Ausgestaltungen der supraleitenden Einrichtung gemäß der Erfindung gehen aus den Unteransprüchen hervor.

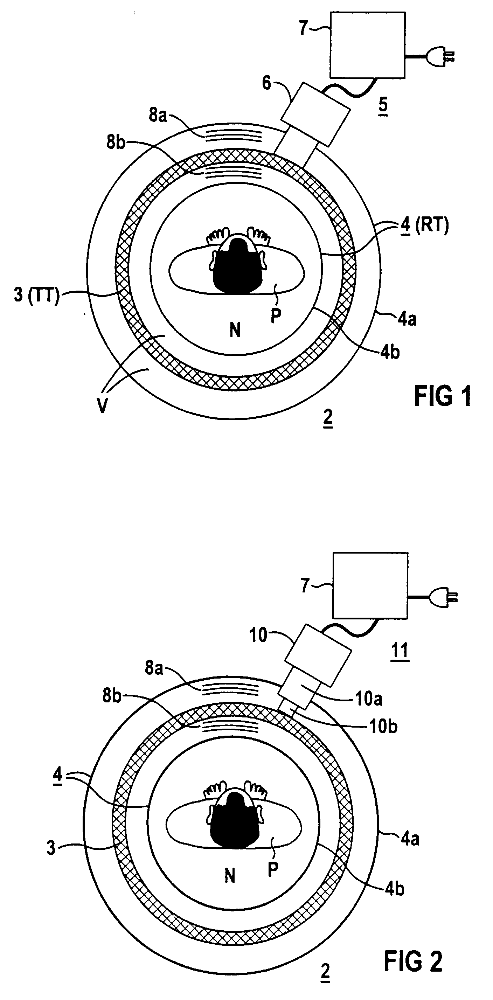

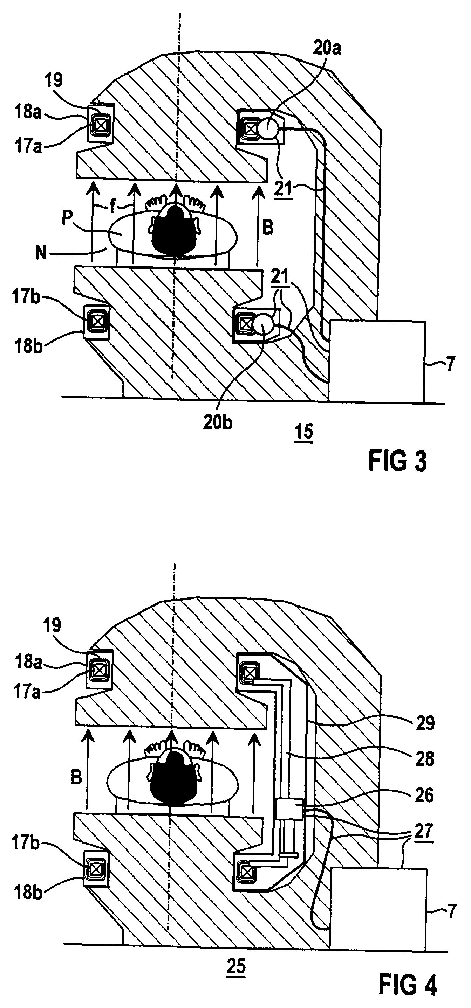

Die Erfindung wird nachfolgend anhand von Ausführungsbeispielen unter Bezugnahme auf die Zeichnung noch weiter erläutert. Dabei zeigen in der Zeichnung jeweils schematisch
- deren Figur 1: einen Schnitt durch einen supraleitenden Magneten mit einem einstufigen Kühler,
- deren Figur 2: einen Schnitt durch einen Magneten mit einem zweistufigen Kühler,
und
- deren Figuren 3 und 4: jeweils im Schnitt einen C-förmigen Magneten einer Kernspintomographie-Anlage mit supraleitenden Magneteinrichtungen gemäß der Erfindung.
Dabei sind in den Figuren sich jeweils entsprechende Teile mit denselben Bezugszeichen versehen.

Bei der in Figur 1 gezeigten supraleitenden Einrichtung gemäß der Erfindung handelt es sich insbesondere um einen supraleitenden Grundfeldmagneten einer Anlage zur Kernspintomographie bzw. zur Nuclear Magnetic Resonance (NMR) bzw. zum Magnetic Resonance Imaging (MRI). Der prinzipielle Aufbau eines solchen Magneten ist allgemein bekannt. Der mit 2 bezeichnete Magnet enthält dabei mindestens eine supraleitende Magnetwicklung 3 insbesondere mit rohrförmigem Querschnitt. Entsprechende Magnetwicklungen bilden insbesondere eine Solenoidform und/oder sind Teil eines Spulensystems aus mehreren in einer Achsrichtung hintereinander angeordneten Spulen. Die Wicklung soll mit Leitern aus einem der bekannten HTS-Materialien wie z.B. einem Bi-Cuprat aufgebaut sein. Sie ist in einem sie konzentrisch umschließenden, evakuierten Vakuumgehäuse 4 mit einer äußeren, hohlzylindrischen Gehäusewand 4a und einer inneren, hohlzylindrischen Gehäusewand 4b umgeben. Das Vakuumgehäuse liegt dabei zumindest annähernd auf Raumtemperatur RT. Demgegenüber werden die Leiter der Magnetwicklung 3 von einer Kältemaschine 5 auf einer tiefen Betriebstemperatur TT von deutlich unterhalb 77 K, beispielsweise auf einer Temperatur zwischen 10 und 50 K, insbesondere zwischen 15 und 40 K gehalten. Bei der Kältemaschine kann es sich um einen Kryokühler vom Gifford-McMahon-Typ handeln, der beispielsweise einstufigen Kaltkopf 6 und einen daran angeschlossenen Kompressor 7 umfaßt. Der Kompressor versorgt den Kaltkopf mit He-Druckgas. Zur Verminderung der Wärmeeinleitung von den warmen Gehäusewänden 4a und 4b in dem Bereich der gekühlten Magnetwicklung 3 sind thermische Isolationsmittel vorgesehen, die gemäß der Erfindung nicht gekühlt werden. Darunter wird verstanden, daß diese Isolationsmittel nicht diskret auf ein Zwischentemperaturniveau zwischen der tiefen Betriebstemperatur TT der Magnetwicklung und der Raumtemperatur RT des Vakuumgehäuses mittels eines Kühlmittels oder einer Kältemaschine gelegt werden und daß insbesondere auf einen gekühlten Strahlungsschild verzichtet wird. D.h., zur thermischen Isolation dienen lediglich das Vakuum V in den Zwischenräumen zwischen der Magnetwicklung und den Gehäusewänden sowie die dort befindlichen thermischen Isolationsmittels 8a und 8b. Wie in der Figur auszugsweise angedeutet sein soll, können als thermische Isolationsmittels insbesondere Lagen aus sogenannter Superisolationsfolie dienen. Es sind aber auch andere bekannte thermische Isolationsmittel wie z.B. Isolationsvliese, Isolationspulver oder geschäumte Isolationsmaterialien geeignet. Diese Isolationsmittel können auch miteinander oder mit weiteren bekannten thermischen Isolationsmitteln kombiniert sein. Es wurde erkannt, daß die Wärmelasten auf das kalte System sich dann durch Optimierung aller Verlustprozesse wie Wärmestrahlung, Aufhängung der Magnetwicklung, Stromzuführungen und Dissipation in der supraleitenden Wicklung durch resistive Prozesse so klein halten lassen, daß auf einen besonderen Strahlungsschild verzichtet werden kann. Trotzdem ist der Betrieb mit einer leistungsfähigen, einstufigen Kältemaschine bei 20 bis 30 K unter wirtschaftlichen Gesichtspunkten möglich, z.B. mit einem Gifford-McMahon-Refrigerator vom Typ 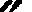 Leibold RGS 120-T", der eine Wärmelast von 25 W bei 20 K abführen kann.

Wie in Figur 1 ferner angedeutet ist, umschließt das Vakuumgehäuse 4 mit seiner inneren Gehäusewand 4b einen Nutzraum N auf Raumtemperatur RT, der zur Aufnahme eines zu untersuchenden Patienten P dient.

Selbstverständlich sind ebenfalls unter Verzicht auf einen Strahlungsschild auch mehrstufige Kältemaschinen verwendbar, wobei z.B. eine erste Stufe einer solchen Maschine z.B. eine Stromzuführung zwischenkühlt und eine zweite Stufe zur Kühlung der HTS-Wicklung herangezogen wird. Ein entsprechendes Ausführungsbeispiel zeigt Figur 2. Gegenüber der Ausführungsform nach Figur 1 wird hier die Magnetwicklung 3 des supraleitenden Magneten 2 von einem zweistufigen Kaltkopf 10 einer Kältemaschine 11 gekühlt. Die zweite Stufe des Kaltkopfes kühlt dabei die Wicklung z.B. auf 15 bis 40 K durch Wärmeleitung. Zur Verbesserung der Wärmeabfuhr können darüber hinaus noch weitere Maßnahmen zum Einsatz kommen, wie z.B. Gasströme oder Wärmerohre (sogenannte 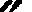 head pipes") . Die in der Figur nicht dargestellten Stromzuführungen verlaufen im Vakuum V zwischen der äußeren, raumtemperaturseitigen Gehäusewand 4a des Vakuumgehäuses 4 und einem Kaltflansch der tieftemperaturseitigen Magnetwicklung 3. Sie können vorteilhaft an der ersten Stufe 10a der Kältemaschine thermisch abgefangen werden. Vorteilhaft ist auch der Einsatz von HTS-Leitern für die Stromzuführung zwischen der ersten Stufe 10a auf etwa 70 bis 100 K und der von der zweiten Stufe 10b auf etwa 15 bis 40 K gehaltenen Magnetwicklung 3. Ebenfalls ist eine Zwischenkühlung von Spulenaufhängungen möglich. Zur Beschleunigung des Abkühlens der Magnetwicklung von Raumtemperatur aus kann vorteilhaft ein Wärmeschalter verwendet werden, beispielsweise ein Gas-Schalter oder mechanischer Schalter. Die Kältemaschine kann wiederum ein Gifford-MacMahon-, Stirling- oder vorteilhaft ein Pulsröhrenkühler sein, dessen Vibrationen vorteilhaft reduziert sind. Es ist auch möglich, Hybridtypen zu verwenden, bei denen z.B. die erste Stufe aus einem Gifford-McMahon-Kühler und die zweite Stufe aus einem Pulsröhrenkühler besteht.

Alternativ können auch zwei einstufige Kältemaschine verwendet werden, wobei eine Maschine die Magnetwicklung auf 15 bis 40 K kühlt. Die andere Maschine kann dann auf einer höheren Temperatur von beispielsweise 70 bis 100 K die erforderlichen Stromzuführungen zwischenkühlen, wobei der Teil der Stromzuführungen auf niedrigerer Temperatur auch aus HTS-Material bestehen kann. Ebenfalls ist eine Zwischenkühlung von Spulenaufhängungen möglich. Die beiden Kältemaschinen können auch aus einer Kombination von Gifford-McMahon-, Stirling- und/oder Pulsröhrenkühler bestehen.

Darüber hinaus können auch eine einstufige und eine zweistufige Kältemaschine verwendet werden, wobei die zweite Stufe die Magnetwicklung auf 15 bis 40 K kühlt. Die einstufige Maschine kann auf einer höheren Temperatur von etwa 70 bis 100 K die Stromzuführung zwischenkühlen, wobei wiederum der Teil der Stromzuführung auf niedrigerer Temperatur auch aus HTS-Material bestehen kann. Auch hier ist eine Zwischenkühlung von Spulenaufhängungen möglich. Beide Kältemaschinen können aus einer Kombination der genannten Kühler bestehen.

Bei dem in Figur 3 im Schnitt gezeigten Kernspintomographie-Magneten 15 als supraleitender Einrichtung gemäß der Erfindung wird von bekannten Ausführungsformen mit C-förmigem Eisenjoch 16 ausgegangen (vgl. z.B. EP 0 616 230 A).

Das Eisenjoch 16 wird durch zwei supraleitende Magnetwicklungen 17a und 17b mit HTS-Leitern magnetisiert. In den die Wicklungen 17a und 17b umschließenden, getrennten Vakuumgehäusen 18a und 18b sind keinerlei Strahlungsschilde vorhanden. Lediglich sind als thermische Isolationsmittel 19 neben der Evakuierung der Vakuumgehäuse lediglich bekannte Mehrlagen-Superisolationsfolien vorgesehen. Je ein Kaltkopf 20a bzw. 20b einer Kältemaschine 21 kühlt die jeweils zugeordnete Magnetwicklung 17a bzw. 17b indirekt durch Wärmeleitung auf die geforderte Betriebstemperatur von z.B. 15 bis 40 K. Je nach erforderlicher Leistung werden diese Kaltköpfe von einem oder mehreren Kompressoren 7 mit He-Druckgas versorgt. In der Figur ist ferner die in einem einen Patienten P aufnehmenden Untersuchungsbereich bzw. in dem Nutzraum N erzeugte magnetische Induktion B durch Feldlinien f des zugeordneten Magnetfeldes veranschaulicht.

Der in Figur 4 gezeigte MRI-Magnet 25 unterscheidet sich von dem MRI-Magneten gemäß Figur 3 lediglich durch die andere Kühlung seiner Magnetwicklungen 17a und 17b. Hier kühlt ein einstufiger Kaltkopf 26 einer Kältemaschine 27 beide Magnetwicklungen mittels eines gut wärmeleitenden Verbindungsteils 28 auf die erforderliche Tieftemperatur. Dieses Verbindungsteil 28 kann beispielsweise eine Cu- oder Al-Stange, ein Wärmerohr (sogenannte 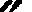 head pipe") oder ein Gaskreislauf sein und ist aus thermischen Isolationsgründen in einem Vakuumgehäuse 29 untergebracht. Dieses Vakuumgehäuse kann beispielsweise mit den Vakuumgehäusen 18a und 18b der Magnetwicklungen einen gemeinsamen Vakuumraum bilden oder auch von diesen vakuummäßig getrennt sein.

Statt des gemäß den Figuren 3 und 4 angenommenen Eisenjochs mit C-Form können selbstverständlich auch anders geformte Eisenjoche wie z.B. in H-Form oder in Tempel-Form für die Kernspintomographie-Magnete vorgesehen sein, um mit Wicklungen gemäß der Erfindung ausgestattet zu werden.

Für die gezeigten supraleitenden Einrichtungen gemäß der Erfindung können je nach Größe des Systems auch mehrere Kaltköpfe verwendet werden. Darüber hinaus läßt sich je nach System auch eine Vielzahl von supraleitenden Wicklungen über einen gemeinsamen Wärmebus kühlen. Als Wicklungen kommen Luftspulen oder Spulen in Kombination mit Eisen zur Induktionsverstärkung, Feldformung und/oder Abschirmung in Frage. Die Wicklungen können dabei Teil von supraleitenden Einrichtungen wie Magneten, Transformatoren, Generatoren oder Motoren sein, falls ein HTS-Material vorgesehen ist, das auf einem Temperaturniveau von deutlich unter 77 K zu halten ist.

Gemäß den dargestellten Ausführungsbeispielen wurde davon ausgegangen, daß für die supraleitenden Wicklungen mit HTS-Material auf Tieftemperatur eine als besonders vorteilhaft anzusehende indirekte Kühlung vorgesehen wird. Gegebenenfalls kann aber auch die mindestens eine Wicklung der supraleitenden Einrichtung nach der Neuerung von einem Wicklungsgehäuse umschlossen sein, das zur Aufnahme eines die Leiter der Wicklung kühlenden Kühlmittels wie insbesondere He nach Art einer Badkühlung dient. Das Kühlmittel braucht dabei nicht unbedingt verflüssigt zu sein. Stattdessen ist auch eine forcierte Kühlung möglich, falls die Supraleiter der mindestens einen Wicklung wenigstens einen hierfür erforderlichen, vakuumdichten Kühlmittelkanal aufweisen.

## Patentansprüche

1. Supraleitende Einrichtung mit einem raumtemperaturseitigen Vakuumgehäuse, in dem sich mindestens eine supraleitende Wicklung befindet, deren Leiter ein Hoch-T_{c}-Supraleitermaterial enthalten und auf einem Temperaturniveau unterhalb von 77 K gehalten sind, und mit thermischen Isolationsmitteln zwischen der Wicklung und dem Vakuumgehäuse, **dadurch gekennzeichnet,** daß alle zwischen der Wicklung (3; 17a, 17b) und dem Vakuumgehäuse (4; 18a, 18b) befindlichen thermischen Isolationsmittel (8a, 8b; 19) ungekühlt sind.

2. Einrichtung nach Anspruch 1, **dadurch gekennzeichnet,** daß die thermischen Isolationsmittel (8a, 8b; 19) Superisolationsfolien und/oder Isolationsvliese und/oder Isolationspulver und/oder geschäumtes Isolationsmaterial zumindest enthalten.

3. Einrichtung nach Anspruch 1 oder 2, **dadurch gekennzeichnet,** daß die mindestens eine Wicklung von einem Wicklungsgehäuse umschlossen ist, das zur Aufnahme eines die Leiter der Wicklung kühlenden Kühlmittels vorgesehen ist.

4. Einrichtung nach Anspruch 1 oder 2, **dadurch gekennzeichnet,** daß die mindestens eine Wicklung mit Supraleitern aufgebaut ist, die wenigstens einen vakuumdichten Kühlmittelkanal aufweisen, durch den forciert das die Leiter kühlende Kühlmittel zu fördern ist.

5. Einrichtung nach Anspruch 1 oder 2, **dadurch gekennzeichnet,** daß die mindestens eine Wicklung (3; 17a, 17b) indirekt gekühlt ist mittels thermischer Ankopplung an einen kalten Teil einer Kältemaschine (5, 11, 21, 27).

6. Einrichtung nach Anspruch 5, **dadurch gekennzeichnet,** daß die Kältemaschine vom Gifford-McMahon-Typ oder vom Stirling-Typ oder ein Pulsröhrenkühler ist.

7. Einrichtung nach Anspruch 5 oder 6, **dadurch gekennzeichnet,** daß die Kältemaschine (5, 11, 21, 27) wenigstens einen an die mindestens eine Wicklung (3; 17a, 17b) thermisch angekoppelten Kaltkopf (6, 10, 20a, 20b, 26) enthält.

8. Einrichtung nach Anspruch 7, **dadurch gekennzeichnet,** daß der wenigstens eine Kaltkopf (6, 10, 20a, 20b, 26) ein- oder mehrstufig ausgeführt ist.

9. Einrichtung nach einem der Ansprüche 5 bis 8, **dadurch gekennzeichnet,** daß zur thermischen Ankopplung ein thermisch gut leitender Verbindungsteil (28), insbesondere eine Cu- oder Al-Stange oder ein Wärmeleitungsrohr oder ein Gaskreislauf vorgesehen ist.

10. Einrichtung nach einem der Ansprüche 1 bis 9, **dadurch gekennzeichnet,** daß die mindestens eine Wicklung (3; 17a, 17b) Teil eines Magneten (2, 15, 25) einer Kernspintomographie-Anlage ist.

11. Einrichtung nach einem der Ansprüche 1 bis 10, **dadurch gekennzeichnet,** daß die mindestens eine Wicklung (3) rohrförmig gestaltet ist.

12. Einrichtung nach Anspruch 10, **dadurch gekennzeichnet,** daß die mindestens eine Magnetwicklung (17a, 17b) an einem C-förmigen Eisenjoch (16) des Magneten (15, 25) befestigt ist.

13. Einrichtung nach Anspruch 12, **dadurch gekennzeichnet,** daß zwei Magnetwicklungen (17a, 17b) jeweils in einem eigenen Vakuumgehäuse (18a, 18b) angeordnet sind und jeweils von mindestens einem eigenen Kaltkopf (20a, 20b) wenigstens einer Kältemaschine (21) gekühlt sind.

14. Einrichtung nach Anspruch 12, **dadurch gekennzeichnet,** daß zwei Magnetwicklungen (17a, 17b) jeweils in einem Vakuumraum eines Vakuumgehäuses angeordnet sind, zwischen welchen Vakuumgehäusen ein weiteres Vakuumgehäuse (29) angeordnet ist, in dessen Vakuumraum mindestens ein Kaltkopf (26) wenigstens einer Kältemaschine (27) angeordnet ist, der in wärmeleitender Verbindung (Verbindungselement 28) mit den Magnetwicklungen (17a, 17b) steht.

15. Einrichtung nach Anspruch 14**, dadurch gekennzeichnet,** daß die Vakuumräume der Magnetwicklungen (17a, 17b) und des Kaltkopfes (26) einen gemeinsamen Vakuumraum eines gemeinsamen Vakuumgehäuses bilden.

16. Einrichtung nach einem der Ansprüche 1 bis 15, **dadurch gekennzeichnet,** daß die mindestens eine Wicklung (3; 17a, 17b) auf einer Temperatur zwischen 10 K und 50 K, vorzugsweise zwischen 15 K und 40 K, gehalten ist.

17. Einrichtung nach einem der Ansprüche 1 bis 16, **dadurch gekennzeichnet,** daß das Hoch-T_{c}-Supraleitermaterial ein Bi-Cuprat ist.
